# EUROPEAN PATENT APPLICATION

(11) **EP 1 911 579 A1**
(43) Date of publication of application: **16.04.2008**
(21) Application number: 07019357.8
(22) Date of filing: 02.10.2007
(51) Int. Cl.: B32B 27/38, C08G 59/40, C08G 59/68, C08L 63/00, H01L 21/56, H01L 23/29, H01L 23/31

(54) **Epoxy resin composition for encapsulating semiconductor device and thin semicondutor device**

(30) Priority: 04.10.2006 JP 2006273061
(71) Applicant: Shin-Etsu Chemical Co., Ltd., Tokyo (JP)
(72) Inventor: Osada, Shoichi, Annaka-shi Gunma-ken (JP)
(74) Representative: Merkle, Gebhard

(57) **Abstract**

An epoxy resin composition for encapsulating a semiconductor device is provided. This composition contains the following components (A), (C), (D), (E), (F) and (G) as critical components:
(A) an epoxy resin;
(C) an inorganic filler;
(D) a curing accelerator of the general formula (1): 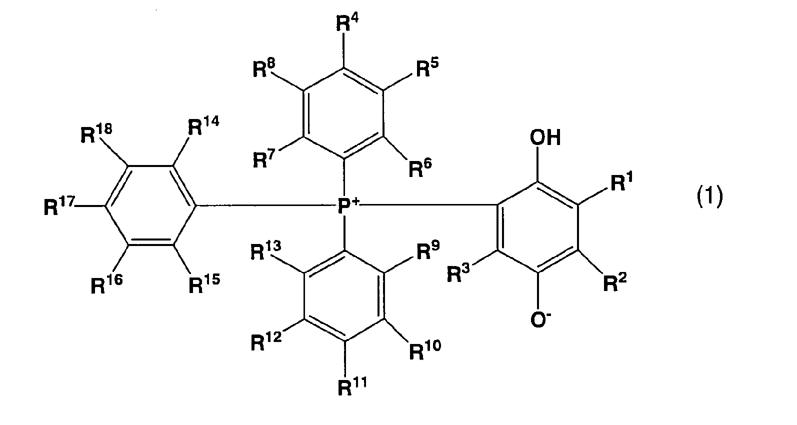 (E) a radical initiator;
(F) a compound having at least two maleimide group per molecule; and
(G) a phenol compound having at least one alkenyl group per molecule.

## Description

### TECHNICAL FIELD

This invention relates to a thin semiconductor device having an improved resistance to chemicals such as acids and petroleum solvents, and which is well adapted for use in automobiles near its engine or IC cards requiring high security reliability.

### BACKGROUND ART

Current semiconductor device such as diode, transistor, IC, LSI, and VLSI are mostly encapsulated with a resin, and the semiconductor device is typically encapsulated with an epoxy resin since this resin is superior in its moldability, adhesion, mechanical properties, and moisture resistance compared with other thermosetting resins.

The semiconductor device, however, is used under increasingly severe conditions. For example, in the field of automobile electronic components, employment of internal pressure sensor capable of detecting leakage of the gasoline as well as electronic control of engine and engine-related components are contemplated, and this will require further improvement in heat resistance and solvent resistance of the semiconductor device.

Another example is IC cards which were developed the 1970s. IC cards have a semiconductor device (IC chip) assembled in the card for the purpose of recording the information and calculation. Since this IC card is capable of storing the information at an amount several thousand times larger than the conventional magnetic stripe cards, and conducting information processing in the card, this card is used in a wide diversity of applications in the market, for example, in the field of communication as a prepaid card of public phones or license card of digital broadcasting; as a payment means such as credit card or cash card; and in the field of transportation as in the case of "Suica" of East Japan Railway Company or ETC card of Japan Highway Public Corporation. This IC card has also been widely employed in the field of administration, for example, as a citizen card, basic register of residents, and passport.

Magnetic cards are being replaced with the IC cards because the IC cards are much harder to counterfeit. Information written in the magnetic stripe is vulnerable to unauthorized reading and writing, and therefore, the information of the magnetic cards can be altered and copied by a relatively inexpensive apparatus, while access to the information recorded in the IC card is controlled by a semiconductor device, and unauthorized copying of such an IC card would require disassembly of the IC card and analysis of its interior by a specialized IC failure analysis system. The effort and cost required for such analysis are believed to provide higher safety of the IC cards.

However, since 1990s, there have been reports on the success of reading the information called "secret key" required for cryptanalysis as well as reading of substantially entire analysis of the circuit structure, internal action, and physical structure by exposing the semiconductor device using an LSI failure analysis system.

In analyzing a semiconductor failure, the resin encapsulating the semiconductor device should be removed by a physical or chemical means with no damage whatsoever on the semiconductor device. The physical removal is accomplished by grinding and polishing the encapsulating resin on the semiconductor device with a grinder, drill, and the like. This technique, however, requires stopping of the resin removal just before the exposure of the semiconductor device, and the remaining resin is then removed by immersion in an organic solvent, an inorganic acid, and the like to thereby chemically dissolve and remove the remaining resin. This is a manual procedure requiring a skilled workmanship. Accordingly, the exposure of the semiconductor failure analysis is commonly accomplished by using a semiconductor decapsulation system which are sold for the purpose of semiconductor failure analysis. Exemplary such semiconductor decapsulation systems include those using an acid for the etching such as PS-103A and PS102W/PS102S manufactured by Nippon Scientific Co., Ltd. and those using an active ion gas for the etching such as ES312 manufactured by Nippon Scientific Co., Ltd. Typical acids used for such etching include fuming nitric acid, conc. sulfuric acid, and a mixture of sulfuric acid and nitric acid.

In consideration of further spread of the IC cards, improvement in the security by using an encapsulation resin having a higher chemical resistance, and in particular, a higher acid resistance is inevitable.

IC card include IC card with contacts defined by ISO/IEC7816 or JIS 6300-X, close coupling contactless IC card defined by ISO/IEC10536 or JIS 6321, vicinity contactless IC card defined by ISO/EC14443 or JIS 6322, and proximity contactless IC card defined by ISO/IEC15693 or JIS 6323. Standard thickness of the IC card is 0.76 mm, and the semiconductor device used in such IC card typically has a thickness of up to 0.58 mm.

Reduction in the thickness is also taking place in common semiconductor devices. In the case of devices such as TQFP (Thin Quad Flat Package), TSOP (Thin Small Outline Package), and TSSOP (Thin Shrink Small Outline Package), products with a thickness of up to 1.1 mm have become mainstream, and in the case of devices encapsulated only on one side such as BGA (Ball Grid Array) and QFN (Quad Flat Non Lead), mainstream thickness is up to 1.2 mm.

In these thin packages, thickness of the resin encapsulation protecting the interior semiconductor device is simultaneously reduced, and the semiconductor device is more susceptible to the influence of chemicals compared to the conventional thicker devices. For example, the resin may become swollen by the petroleum solvents such as gasoline and engine oil, and this swelling may induce electric and mechanical failures. Thinner resin encapsulation also means easier decapsulation of the semiconductor device by a semiconductor decapsulation system using an acid, which may invite fraud use of the IC card by exposing the semiconductor device embedded in the IC card and elucidating the circuit structure, internal action, and physical structure.

Glass transition temperature of the epoxy resins which have been commonly used in the encapsulation has been about 200 to 220°C at the highest. Other resins having a high glass transition temperature include super engineering plastics such as polyphenylene sulfide, polyether ether ketone, and polytetrafluoroether. These resins, however, are thermoplastic resins that require an injection molding at a high temperature and high pressure, and use of such resin for the encapsulation of a semiconductor device produced by using a gold wire having a diameter of less than 30 microns is inadequate. Another resin having a high glass transition temperature is polyimide. This resin, however, is commonly used by dissolving in a solvent, and coating the thus obtained varnish to a thickness of about several dozen µm, and use of this resin for encapsulation with the thickness of not less than 100 µm is difficult.

The related arts may be as follows.
Patent Document 1: Japanese Patent No. 3295643
Patent Document 2: JP-A 2000-17052
Patent Document 3: JP-A 2003-212958
Patent Document 4: JP-A 2003-128757

### DISCLOSURE OF THE INVENTION

The present invention has been accomplished in view of the situation as described above, and an object of the present invention is to provide an epoxy resin composition adapted for used in encapsulating a semiconductor device which has a high resistance to chemicals, and in particular, a high resistance to acids and petroleum solvents, and which is well adapted for use in automobiles near their engines, and for IC cards which should have a high security reliability. Another object of the present invention is to provide a thin semiconductor device produced by using such epoxy resin composition.

The inventors of the present invention made an intensive study to realize the objects as described above, and found that, when a semiconductor device is encapsulated with an epoxy encapsulation resin having a glass transition temperature of at least 250°C prepared by curing the composition as described below, the time required for exposing the surface of the semiconductor device in a semiconductor decapsulation system can be exponentially increased, and swelling of the resin in the long time immersion in gasoline, an oil, and the like can also be suppressed. In other words, the inventors found that a thin semiconductor device encapsulated with the cured product of an epoxy resin composition for encapsulating a semiconductor device having a high glass transition temperature of preferably at least 250°C will be provided with a high chemical resistance. The present invention has been completed on the basis of such finding.

Accordingly, this invention provides an epoxy resin composition for encapsulating a semiconductor device containing the following components (A), (C), (D), (E), (F) and (G) as critical components:
(A) an epoxy resin;
(C) an inorganic filler;
(D) a curing accelerator represented by the following general formula (1): 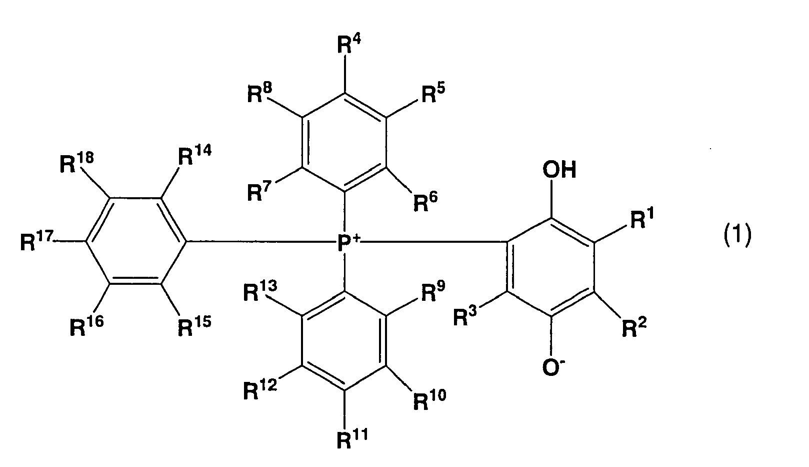 wherein R¹, R², and R³ are independently hydrogen atom, an alkyl group containing 1 to 4 carbon atoms, an aryl group, or hydroxyl group; R⁴ to R¹⁸ are independently hydrogen atom, or an alkyl group or an alkoxyl group containing 1 to 4 carbon atoms;
(E) a radical initiator;
(F) a compound having at least two maleimide group per molecule at an amount of 30 to 60 parts by weight in relation to 100 parts by weight of the total of the component (A), (D), (E) and (F); and
(G) a phenol compound having at least one alkenyl group per molecule at an amount such that molar amount of the alkenyl group is 0.1 to 1.0 mole in relation to 1 mole of the maleimide group in the component (F).

This epoxy resin composition may contain a phenol resin curing agent as the component (B). The encapsulation resin which is obtained by curing the epoxy resin composition may preferably have a glass transition temperature of at least 250°C.

The present invention also provides a thin semiconductor device which has been encapsulated by a layer of the encapsulation resin which is obtained by curing the epoxy resin composition. The semiconductor device has a thickness of up to 1.2 mm, and the layer of the encapsulation resin formed on the semiconductor device has a thickness in the range of 0.10 mm to 0.40 mm.

The epoxy resin composition for encapsulating a semiconductor device as described above has a high moldability, and once cured, it will acquire high glass transition temperature (Tg) as well as low dielectric constant. The semiconductor device encapsulated with the cured product (the encapsulation resin) of such epoxy resin compositions have an improved high temperature reliability, high humidity reliability, and high thermal shock resistance.

### EFFECTS OF THE INVENTION

The composition of the present invention is capable of providing a cured article having a glass transition temperature of at least 250°C, which could not have been achieved by the conventional epoxy resin composition. This cured article is not only excellent in the heat resistance properties but also in resistance to chemicals such as acids and petroleum solvents. Accordingly, a semiconductor device which has been encapsulated by the cured product (encapsulation resin) of the inventive composition is well adapted for industrial applications such as automobile applications and thin semiconductor device applications including IC cards.

### BRIEF DESCRIPTION OF THE DRAWINGS

FIG. 1 is a schematic view showing the semiconductor device used in the Examples.
FIG. 2 shows decapsulation time of the semiconductor device (the time required for exposure of the encapsulated semiconductor device) in relation to the glass transition temperature.
FIG. 3 is a graph showing change in the size in relation to the temperature (used in determining the glass transition temperature).

### DESCRIPTION OF THE PREFERRED EMBODIMENTS

Next, the epoxy resin composition used in the present invention which produces an encapsulation resin (cured product) having a glass transition temperature of at least 250°C is described in detail.

### [(A) Epoxy resin]

The epoxy resin used for the component (A) of the epoxy resin composition of the present invention is not particularly limited. Exemplary typical epoxy resins include novolac epoxy resin, cresol novolac epoxy resin, triphenol alkane epoxy resin, aralkyl epoxy resin, biphenyl skeleton-containing aralkyl epoxy resin, biphenyl epoxy resin, dicyclopentadiene epoxy resin, heterocyclic epoxy resin, naphthalene ring-containing epoxy resin, bisphenol A epoxy compound, bisphenol F epoxy compound, and stilbene epoxy resin, which may be used alone or in combination of two or more. Among these, the preferred are epoxy resins containing an aromatic ring, and the more preferred are polyfunctional epoxy resins having a plurality of epoxy functional groups such as triphenol alkane epoxy resin and cresol novolac epoxy resin.

The epoxy resin may preferably contain a hydrolyzable chlorine at a content of up to 1,000 ppm, and in particular, up to 500 ppm, and sodium and potassium at a content of up to 10 ppm. When the content of the hydrolyzable chlorine is in excess of 1,000 ppm or the sodium or potassium content is in excess of 10 ppm, the semiconductor device may experience loss of moisture resistance when stored under a high temperature, high humidity condition for a prolonged period.

### [(B) Curing agent]

The curing agent component (B) is not a critical component in the present invention. However, a curing agent commonly used in the art may be incorporated at an amount not adversely affecting the object of the present invention.

Exemplary preferable curing agents which may be used for the component (B) include phenol resins such as phenol novolac resin, naphthalene ring-containing phenol resin, aralkyl phenol resin, triphenol alkane phenol resin, biphenyl skeleton-containing aralkyl phenol resin, biphenyl phenol resin, alicyclic phenol resin, heterocyclic phenol resin, naphthalene ring-containing phenol resin, bisphenol A, and bisphenol F, which may be used alone or in combination of two or more.

The curing agent may preferably contain sodium and potassium respectively at a content of up to 10 ppm as in the case of the epoxy resin. When the curing agent has the sodium or potassium content in excess of 10 ppm, the semiconductor device may experience loss of moisture resistance when stored under a high temperature, high humidity condition for a prolonged period.

Amount of the component (B) incorporated in relation to the component (A) is not particularly limited, and an amount effective for curing the epoxy resin commonly used in the art may be employed. When a phenol resin is used for the curing agent, the component (B) is typically used so that molar ratio of the phenolic hydroxy group in the curing agent to 1 mole of the epoxy group in the component (A) is in the range of 0.5 to 1.5, and in particular, 0.8 to 1.2.

### [(C) Inorganic filler]

The inorganic filler (C) incorporated in the epoxy resin composition of the present invention may be any filler commonly used in the epoxy resin composition. Exemplary such inorganic fillers include silicas such as fused silica, crystalline silica, and cristobalite, alumina, silicon nitride, aluminum nitride, boron nitride, titanium oxide, and glass fiber.

The inorganic filler is not particularly limited for its average particle size, shape, or content. The average particle size, however, is preferably 5 to 30 µm, and the content is preferably 400 to 1,200 parts by weight, and in particular, 500 to 1,000 parts by weight in relation to 100 parts by weight of the total amount of the component (A), (F), and (G), and when the component (B) is used, the total amount of the component (A), (B), (F), and (G).

The inorganic filler incorporated is preferably the one preliminarily subjected to a surface treatment with a coupling agent such as a silane coupling agent and a titanate coupling agent. Preferable examples of such coupling agent include epoxy silanes such as γ-glycidoxypropyltrimethoxysilane, γ-glycidoxypropylmethyldiethoxysilane, γ-isocyanate propyltriethoxysilane, γ-ureido propyltriethoxysilane, and β-(3,4-epoxycyclohexyl)ethyltrimethoxysilane: aminosilanes such as N-(β-aminoethyl)-γ-aminopropyltrimethoxysilane, γ-aminopropyltriethoxysilane, and N-phenyl-γ-aminopropyltrimethoxysilane; and mercaptosilanes such as γ-mercaptopropyltrimethoxysilane; which may be used alone or in combination of two or more. The amount of the coupling agent and the method of the surface treatment are not particularly limited.

### [(D) Curing accelerator]

In the present invention, the curing reaction between the epoxy resin and the curing agent is promoted by the compound represented by the following formula (1): 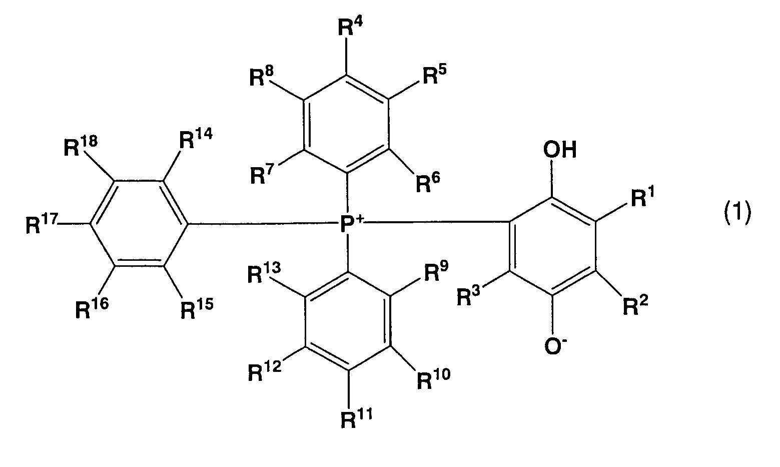 wherein R¹, R², and R³ are independently hydrogen atom, an alkyl group containing 1 to 4 carbon atoms, an aryl group such as phenyl group containing 6 to 12 carbon atoms, or hydroxyl group; and R⁴ to R¹⁸ are independently hydrogen atom or an alkyl group or an alkoxy group containing 1 to 4 carbon atoms.

More specifically, sufficient curability and moldability are not realized by the phosphorus compounds commonly used as an accelerator for the epoxy resin composition such as triphenylphosphine, tributylphosphine, tri(p-methylphenyl)phosphine, tri(nonylphenyl)phosphine, triphenylphosphine·triphenylborane, and tetraphenylphosphine·tetraphenylborate.

On the other hand, use of a tertiary amine compound such as triethylamine, benzyldimethylamine, α-methylbenzyldimethylamine, and 1,8-diazabicyclo(5.4.0)undecene-7, and an imidazole compound such as 2-methylimidazole, 2-phenylimidazole, and 2-phenyl-4-methylimidazole results in the loss of reliable moisture resistance.

In contrast, use of the compound represented by the formula (1) enables production of the molded article having excellent moldability and reliable moisture resistance.

When an ester solvent such as ethyl acetate or butyl acetate is used for producing the addition compound of a tertiary phosphine and a benzoquinone represented by the formula (1), columnar crystals of about 10 µm are obtained with an extremely small amount the residual solvent. In addition, since the target addition compound of the tertiary phosphine and the benzoquinone is obtained at a high purity, failure in the outer appearance generated by the volatile component of the curing accelerator is avoided and the cured article can be produced at an improved continuous moldability. In this case, the addition reaction may be accomplished at a reaction temperature of 40°C to 90°C and preferably 60°C to 80°C for 0.5 to 3 hours, and the resulting precipitate may be collected by filtration and washed with an (ester) solvent and dried at 80°C at a reduced pressure to obtain the addition product having a purity of 98 to 100%.

The curing accelerator of the component (D) may be incorporated at an effective component. More specifically, the compound of formula (1) may be incorporated at 0.1 to 5 parts by weight, and in particular, at 0.5 to 3 parts by weight in relation to 100 parts by weight of the total amount of the components (A), (F), and (G). When incorporated at an amount of less than 0.1 parts by weight, the curing reaction is likely to be retarded and reactivity is likely to be reduced. When incorporated at an amount in excess of 5 parts by weight, curing will proceed too fast to invite molding failures such as wire sweep and insufficient filling.

### [(E) Radical initiator]

The compound of formula (1) promotes curing of the epoxy resin by the curing agent. The compound of formula (1), however, is insufficient as a promoter for the curing of the maleimide compound and the alkenyl phenol compound of the components (F) and (G) as described below. Accordingly, simultaneous incorporation of a radical initiator is necessary as a promoter for the curing of the maleimide compound and the alkenyl phenol compound of the components (F) and (G). Exemplary such radical initiators include peroxides such as benzoyl peroxide, dicumyl peroxide, di-t-butyl peroxide, dilauroyl peroxide, and dibenzoyl peroxide; and azo compounds such as azoisobutyronitrile, 4,4'-azobis(4-cyano valeric acid), and 2,2'-azobis(2,4-dimethyl valeronitrile). Among these, the preferred is dicumyl peroxide in view of the favorable moldability since the temperature for realizing a half life of 1 minute is near the temperature used for the transfer molding.

The radical initiator is incorporated at an amount of 0.05 to 3 parts by weight, and more preferably at 0.1 to 1 parts by weight in relation to 100 parts by weight the total of components (A), (F) and (G). When used at a content of less than 0.05 parts by weight, the composition is less likely to be sufficiently polymerized within the molding time. On the other hand, use in excess of 3 parts by weight is likely to invite increase in the viscosity, which may result in molding failures such as wire sweep and insufficient filling as well as loss of storage ability.

The compound of formula (1) and the radical initiator are used at a weight ratio of the compound of formula (1) to the radical initiator of 0.5 to 6, and preferably 2 to 3.

### [(F) Compound having maleimide group]

The component (F) used in the present invention, namely, the compound having at least two maleimide group per molecule is not particularly limited for its structure, and exemplary such compounds include N,N'-4,4'-diphenylmethane bismaleimide and N,N'-(3,3'-dimethyl-4,4'-diphenylmethane)bismaleimide. Preferable example of such maleimide group-containing compound is the bismaleimide represented by the following formula, for example, BMI (product name, manufactured by K.I. Kasei).

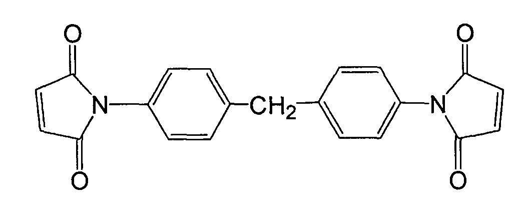

The maleimide compound may be added at an amount of 30 to 60 parts by weight, and in particular, at 40 to 50 parts by weight in relation to 100 parts by weight of the total amount of the components (A), (D), (E), and (F). When the amount is less than 30 parts by weight, the glass transition temperature realized by the matrix of the epoxy group and the phenolic hydroxy group is adversely affected, and incorporation at an amount in excess of 60 parts by weight may result in the loss of flow ability, and molding failure such as wire sweep. In view of realizing well balanced properties of the semiconductor encapsulating material, incorporation of approximately 30 to 60 parts by weight, and in particular, approximately 40 to 50 parts by weight is preferable.

### [(G) Phenol compound having at least one alkenyl group per molecule]

Examples of the phenol compound having at least one alkenyl group per molecule (G) include o,o'-diallyl-bisphenol A, o,o'-di(1-propenyl)-bisphenol A, o-allyl phenol novolac resin, o-(1-propenyl)phenol novolac resin, tris-o-allyl phenol alkane phenol resin, and tris-o-(1-propenyl)phenol alkane phenol resin. In view of the reactivity with the maleimide group-containing compound, the phenol compound having at least one alkenyl group is the one containing 1-propenyl group such as o,o'-di(1-propenyl)-bisphenol A, o-(1-propenyl)phenol novolac resin, and o-(1-propenyl)phenol alkane phenol resin because such compound undergoes cyclization by the addition reaction through Diels-Alder reaction with the bismaleimide group, and this is favorable for heat and chemical resistance.

Examples of the alkenyl group-containing phenol compound include o-(1-propenyl)phenol novolac resin (with the product name of 1PP-2 manufactured by Gun Ei Chemical Industry Co., Ltd.) represented by the following formula: 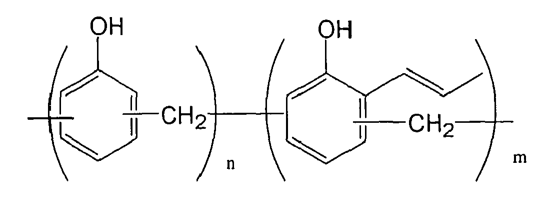 wherein m is 1 to 100, n is 1 to 100, and m + n is 2 to 200.

Amount of the alkenyl group-containing phenol compound is not particularly limited. However, in view of realizing a high glass transition temperature, the alkenyl group is preferably 0.1 to 1.0 mole, and in particular, 0.2 to 0.5 mole in relation to 1 mole of the maleimide group of the component (F).

### [(H) Other components blended in the composition]

If desired, the epoxy resin composition for encapsulating a semiconductor device of the present invention may contain various additives other than the components (A) to (G) to the extent that the objects and benefits of the present invention are not adversely affected. Exemplary such additives include a stress reducing agent such as thermoplastic resin, thermoplastic elastomer, organic synthetic rubber, and silicone; a wax such as carnauba wax, higher fatty acid, and synthetic wax; a colorant such as carbon black; a halogen trapping agent; and a flame retardants such as phosphazene compound and zinc molybdate compound.

Exemplary mold releasing agents include carnauba wax, rice wax, polyethylene, oxidized polyethylene, montanic acid; montan wax which is an ester compound of montanic acid with a saturated alcohol, 2-(2-hydroxyethylamino)-ethanol, ethyleneglycol, glycerin, and the like; stearic acid, stearate ester, stearamide, ethylene bisstearamide, and a copolymer of ethylene and vinyl acetate which may be used alone or in combination of two or more.

Such releasing agent may be blended at an amount of 0.1 to 5 parts by weight, and more preferably at 0.3 to 4 parts by weight in relation to 100 parts by weight of the total of the components (A) and (B).

### [Preparation of the epoxy resin composition]

The epoxy resin composition of the present invention can be produced by blending the components (A) to (G) and other additives at the predetermined compositional ratio; fully blending the mixture in a blender, ball mill, or the like to homogeneity; further blending the mixture in molten state with hot rolls, a kneader, an extruder, or the like; cooling for solidification; and pulverizing the solid to an appropriate size.

In fully blending the composition to homogeneity, the composition is preferably preliminarily treated with a silane coupling agent to improve storage stability or as a wetter.

Examples of such silane coupling agent include γ-glycidoxypropyltrimethoxysilane, γ-glycidoxypropylmethyldiethoxysilane, γ-glycidoxypropyltriethoxysilane, p-styryltrimethoxysilane, γ-methacryloxypropylmethyldimethoxysilane, γ-methacryloxypropyltrimethoxysilane, γ-methacryloxypropylmethyldiethoxysilane, γ-methacryloxypropyltriethoxysilane, γ-acryloxypropyltrimethoxysilane, N-β(aminoethyl) γ-aminopropylmethyldimethoxysilane, N-β(aminoethyl) γ-aminopropyltrimethoxysilane, N-β(aminoethyl) γ-aminopropyltriethoxysilane, γ-aminopropyltrimethoxysilane, γ-aminopropyltriethoxysilane, N-phenyl-γ-aminopropyltrimethoxysilane, γ-mercaptopropylmethyldimethoxysilane, γ-mercaptopropyltrimethoxysilane, bis(triethoxypropyl) tetrasulfide, and γ-isocyanate propyltriethoxysilane, although the type and amount of the silane coupling agent used for the surface treatment is not particularly limited.

The resulting epoxy resin composition of the present invention is effective for use in encapsulating various semiconductor devices. An exemplary method used for the encapsulation is low pressure transfer molding. The curing and molding of the epoxy resin composition of the present invention can be accomplished, for example, by treating the composition at 150 to 200°C for 30 to 300 seconds, and then conducting the post curing at 180 to 260°C for 2 to 16 hours. Post curing at a high temperature for a long time is preferable for realizing a high glass transition temperature.

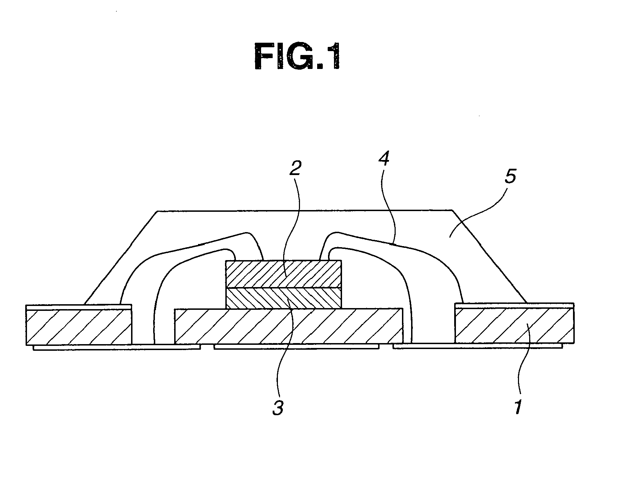

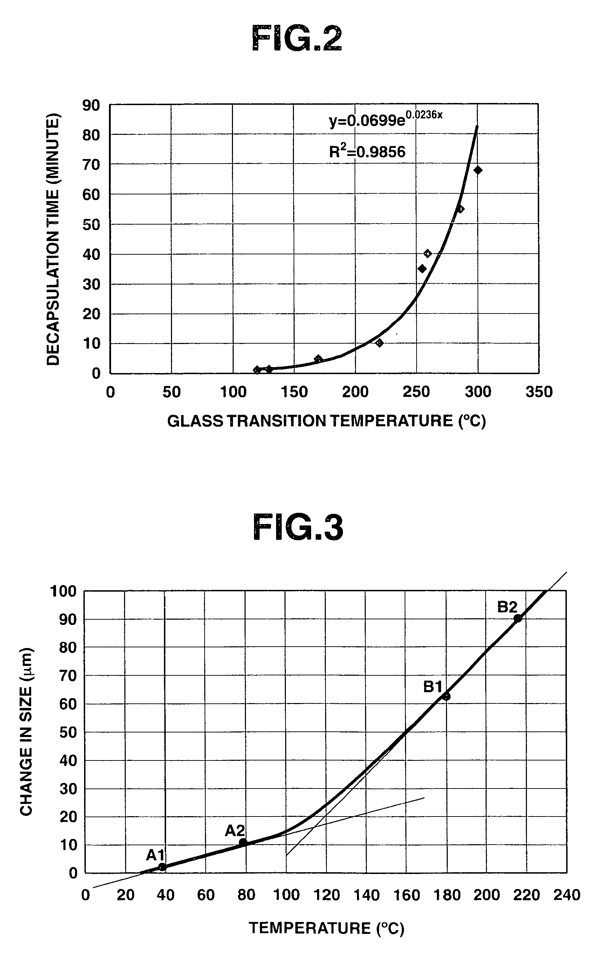

In the semiconductor device encapsulated by an encapsulation resin (cured product) of the resin composition for encapsulating a semiconductor device according to the present invention, it is effective that the encapsulation (cured product) resin preferably has a glass transition temperature (Tg) of at least 250°C, and preferably at least 280°C. The semiconductor device (thickness of the semiconductor device, 0.58 mm; thickness of the encapsulating layer, 0.30 mm) shown in FIG. 1 was evaluated for the decapsulation time (the time required for exposing the surface of the semiconductor device by fuming nitric acid (d = 1.52) heated to 65°C) by using the semiconductor decapsulation system PS-103A (manufactured by Nippon Scientific Co., Ltd.), and the results are shown in FIG. 2. As shown in FIG. 2, the decapsulation time (the time required for exposure of the surface of the semiconductor device) increases exponentially with the increase in the glass transition temperature of the encapsulation resin.

In FIG. 1, 1 is a glass fiber reinforced epoxy resin substrate, 2 is a semiconductor device, 3 is an adhesive, 4 is a bonding wire, and 5 is an encapsulating resin.

As described above, the semiconductor device of the present invention in which the encapsulation resin has a glass transition temperature (Tg) of at least 250°C is well adapted for on-vehicle and security card applications since the resin used for encapsulation has a high chemical resistance.

In the present invention, glass transition temperature was measured by setting a test piece in a thermal delatometer and elevating the temperature to 300°C at a temperature elevation rate of 5°C/minutes under the load of 19.6 mN. A graph showing change in size in relation to the temperature was prepared, and arbitrary two points A1 and A2 on the curve that gives the tangent line at a temperature less than the inflection point, and arbitrary two points B1 and B2 on the curve that gives the tangent line at a temperature in excess of the inflection point were selected. The temperature of the point of intersection of the line including A1 and A2 and the line including B1 and B2 was used for the glass transition temperature.

### EXAMPLES

Next, the present invention is described in further detail by referring to the Examples and Comparative Examples which by no means limit the scope of the present invention.

### Examples 1 to 5 and Comparative Examples 1 to 6

The components shown in Tables 1 and 2 were homogeneously mixed in molten state by using heated dual rolls, and the mixture was cooled and pulverized to produce the epoxy resin composition. The epoxy resin composition was molded at 175°C, 6.9 N/ mm², and a molding time of 120 seconds to produce a test piece of 5 × 5 × 15 mm. The test piece was subjected to post curing under respective conditions and evaluated for its glass transition temperature.

### <Glass transition temperature>

The test piece was placed in a thermal delatometer (Rigaku TMA8140C), and change in size was measured by elevating the temperature to 300°C at a temperature elevation rate of 5°C/minutes under the load of 19.6 mN. The change in size was plotted in relation to the temperature, and arbitrary two points A1 and A2 on the curve that gives the tangent line at a temperature less than the inflection point, and arbitrary two points B1 and B2 on the curve that gives the tangent line at a temperature in excess of the inflection point were selected. The temperature of the point of intersection of the line including A1 and A2 and the line including B1 and B2 was used for the glass transition temperature. FIG. 3 shows typical graph of the change in the size in relation to the temperature.

### <Acid resistance>

The semiconductor device shown in FIG. 1 (thickness of the semiconductor device, 0.58 mm; thickness of the encapsulating layer, 0.30 mm) was evaluated for its decapsulation time (the time required for exposure of the surface of the encapsulated semiconductor device by an acid) by using a decapsulation system PS-103A (manufactured by Nippon Scientific Co., Ltd.). The decapsulation time was measured by using fuming nitric acid (d = 1.52) heated to 65°C for a decapsulation area of 5 × 5 mm.

### <Gasoline resistance>

A test piece (100 × 10 × 0.8 mm) was produced by molding at 175°C for 90 seconds. After the post-curing for a predetermined time, the test piece was immersed in gasoline at 30°C for 1 week. Change in weight after 1 week was measured.
(A) Epoxy resin
   - Epoxy resin a:: o-cresol novolac epoxy resin (EOCN1020-65 manufactured by Nippon Kayaku Co., Ltd.; epoxy equivalent weight, 200)
   - Epoxy resin b:: biphenyl epoxy resin (YX-4000K manufactured by Japan Epoxy Resin Co.,Ltd.; epoxy equivalent weight, 190)
   - Epoxy resin c:: biphenyl aralkyl epoxy resin (NC-3000 manufactured by Nippon Kayaku Co., Ltd.; epoxy equivalent weight, 272)
   - Epoxy resin d:: triphenolalkane epoxy resin (EPPN-502H manufactured by Nippon Kayaku Co., Ltd.; epoxy equivalent weight, 168)
(B) Curing agent
   - Curing agent a:: phenol novolac resin (DL-92 manufactured by Meiwa Plastic Industries, Ltd.; phenolic hydroxy group equivalent weight, 110)
   - Curing agent b:: phenol aralkyl resin (MEH-7800SS manufactured by Meiwa Plastic Industries, Ltd.; phenolic hydroxy group equivalent weight, 175)
   - Curing agent c:: triphenolalkane phenol resin (MEH-7500 manufactured by Meiwa Plastic Industries; Ltd., phenolic hydroxy group equivalent weight, 97)
(C) Inorganic filler
   Spherical molten silica (manufactured by Tatsumori Ltd.; average particle size, 15 µm)
(D) Curing accelerator
   Curing accelerator a: a compound represented by the following formula: 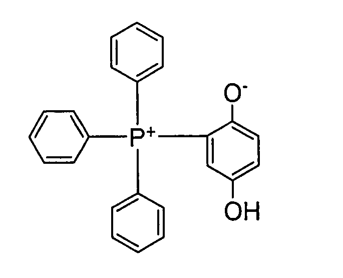 [Method for producing curing accelerator a]
   832.0 g of triphenylphosphine (manufactured by Hokko Chemical Industry Co., Ltd.) was dissolved in 1800.0 g of butyl acetate, and the mixture was stirred at 80°C for 30 minutes. A solution of 352.0 g of 1,4-benzoquinone in 1800 g of butyl acetate was added dropwise at 145 g/minute, and after completing the addition, the mixture was stirred for 1 hour for aging. The mixture was then cooled to room temperature, and the precipitate was collected by filtration, washed, and dried at a reduced pressure to obtain 982.7 g of an adduct of the triphenylphosphine and the 1,4-benzoquinone.
   Curing accelerator b: triphenylphosphine (TPP manufactured by Hokko Chemical Industry Co., Ltd.)
   Curing accelerator c: imidazole compound (2PZ manufactured by manufactured by Shikoku Chemicals Corporation)
(E) Radical initiator
   dicumyl peroxide (Percumyl D manufactured by NOF Corporation)
(F) Maleimide group-containing compound
   a bismaleimide represented by the following formula (BMI, manufactured by K.I. Kasei) 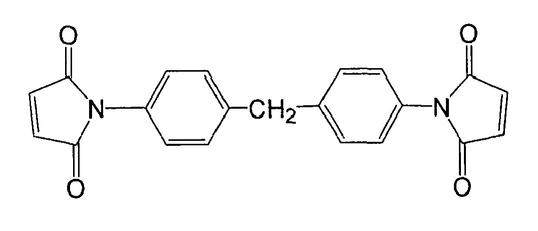
(G) Alkenyl group-containing phenol compound
   o-(1-propenyl)phenol novolac resin represented by the following formula: 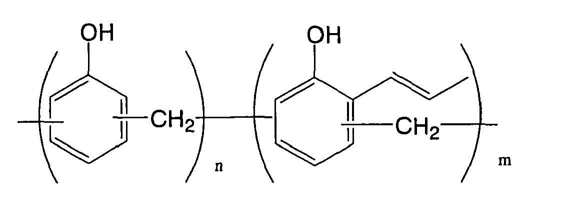 wherein m/n is 1/1.
   (1PP-2 manufactured by Gun Ei Chemical Industry Co., Ltd.)
(H) Other additives
   - Mold release agent:: Carnauba wax (manufactured by Nikko Fine Products Co., Ltd.)
   - Carbon black:: Denka Black (manufactured by Denka)
   - Silane coupling agent:: γ-glycidoxypropyltrimethoxysilane (KBM-403 manufactured by Shin-Etsu Chemical Co., Ltd.)

**Table 1**

| Composition (parts by weight) | | Example | | | | Comparative Example | | | | | |
|---|---|---|---|---|---|---|---|---|---|---|---|
| | | 1 | 2 | 3 | 4 | 1 | 2 | 3 | 4 | 5 | 6 |
| (A) | Epoxy resin a | | | | 45 | | | 65 | | 65 | |
| | Epoxy resin b | | | | | 52 | | | | | |
| | Epoxy resin c | | | | | | 61 | | | | |
| | Epoxy resin d | 40 | 40 | 40 | | | | | 63 | 40 | 40 |
| (B) | Curing agent a | 5 | 5 | 5 | 5 | | | 35 | | 5 | 5 |
| | Curing agent b | | | | | 48 | 40 | | | | |
| | Curing agent c | | | | | | | | 37 | | |
| (C) | Inorganic filler | 600 | 600 | 600 | 600 | 800 | 800 | 600 | 600 | 600 | 600 |
| (D) | Curing accelerator a | 1.5 | 1.5 | 1.5 | 2 | 1 | 1 | | | | 1.5 |
| | Curing accelerator b | | | | | 1 | 1 | | | | |
| | Curing accelerator c | | | | | | | 1.5 | 1.5 | 1.5 | |
| (E) | Radical initiator | 0.5 | 0.5 | 0.5 | 0.5 | | | | | | |
| (F) | Maleimide-containing compound | 40 | 40 | 40 | 40 | | | | | 40 | 40 |
| (G) | Alkenyl-containing phenol compound | 15 | 15 | 15 | 10 | | | | | 15 | 15 |
| Others | Mold release agent | 1.5 | 1.5 | 1.5 | 1.5 | 1.5 | 1.5 | 1.5 | 1.5 | 1.5 | 1.5 |
| | Carbon black | 1.5 | 1.5 | 1.5 | 1.5 | 1.5 | 1.5 | 1.5 | 1.5 | 1.5 | 1.5 |
| | Silane coupling agent | 1.0 | 1.0 | 1.0 | 1.0 | 1.0 | 1.0 | 1.0 | 1.0 | 1.0 | 1.0 |
| Curing condition | Post (C°) cure temperature | 220 | 260 | 260 | 260 | 200 | 200 | 260 | 260 | 260 | 260 |
| | Post cure time (Hr) | 4 | 4 | 16 | 4 | 4 | 4 | 4 | 4 | 4 | 4 |
| properties | Glass transition temperature (Tg) | 260 | 285 | 300 | 255 | 130 | 120 | 170 | 220 | 175 | 240 |
| | Acid resistance | 40 | 55 | 68 | 35 | 1.5 | 1 | 5 | 10 | 4 | 18 |
| | Gasoline resistance (ppm) | <10 | <10 | <10 | <10 | 850 | 740 | 280 | 200 | 900 | 60 |

## Claims

1. An epoxy resin composition for encapsulating a semiconductor device containing the following components (A), (C), (D), (E), (F) and (G) as critical components:
(A) an epoxy resin;
(C) an inorganic filler;
(D) a curing accelerator represented by the following general formula (1): 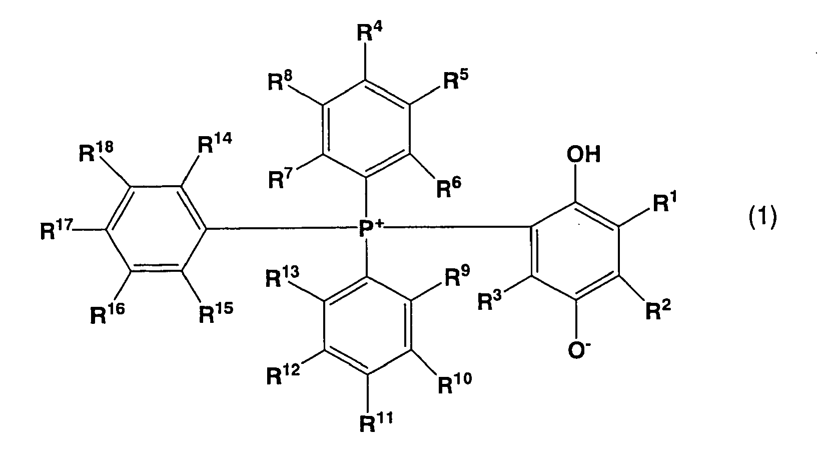 wherein R¹, R², and R³ are independently hydrogen atom, an alkyl group containing 1 to 4 carbon atoms, an aryl group, or hydroxyl group; R⁴ to R¹⁸ are independently hydrogen atom, or an alkyl group or an alkoxyl group containing 1 to 4 carbon atoms;
(E) a radical initiator;
(F) a compound having at least two maleimide group per molecule at an amount of 30 to 60 parts by weight in relation to 100 parts by weight of the total of the component (A), (D), (E) and (F); and
(G) a phenol compound having at least one alkenyl group per molecule at an amount such that molar amount of the alkenyl group is 0.1 to 1.0 mole in relation to 1 mole of the maleimide group in the component (F).

2. The epoxy resin composition according to claim 1 further comprising component (B):
(B) a phenol resin curing agent.

3. The epoxy resin composition according to claim 1 or 2 wherein an encapsulation resin after its curing has a glass transition temperature of at least 250°C.

4. A thin semiconductor device which is encapsulated by a layer of an encapsulation resin obtained by curing the epoxy resin composition of any one of claims 1 to 3, wherein the semiconductor device has a thickness of up to 1.2 mm, and the layer of the encapsulation resin on the semiconductor device has a thickness in the range of 0.10 mm to 0.40 mm.
